# EUROPÄISCHE PATENTSCHRIFT

(11) **EP 2 883 245 B1**
(45) Veröffentlichungstag und Bekanntmachung des Hinweises auf die Patenterteilung: **30.09.2020**
(21) Anmeldenummer: 13773172.5
(22) Anmeldetag: 09.08.2013
(51) Int. Cl.: H01L 23/485, H01L 21/60, G06K 19/077

(54) **KONTAKTHÖCKERVERBINDUNG SOWIE KONTAKTHÖCKER UND VERFAHREN ZUR HERSTELLUNG EINER KONTAKTHÖCKERVERBINDUNG**
CONTACT BUMP CONNECTION AND CONTACT BUMP AND METHOD FOR PRODUCING A CONTACT BUMP CONNECTION
CONNEXION DE PLOTS DE CONTACT ET PLOT DE CONTACT ET PROCÉDÉ D'OBTENTION D'UNE CONNEXION DE PLOTS DE CONTACT

(30) Priorität: 10.08.2012 DE 102012015811
(43) Veröffentlichungstag der Anmeldung: 17.06.2015
(73) Patentinhaber: SMARTRAC TECHNOLOGY GmbH, 70771 Leinfelden-Echterdingen (DE)
(72) Erfinder: NIELAND, Carsten, 99867 Gotha (DE); KRIEBEL, Frank, 01896 Lichtenberg (DE)
(74) Vertreter: Lippert Stachow Patentanwälte Rechtsanwälte Partnerschaft mbB
(86) Internationale Anmeldenummer: PCT/DE2013/000451
(87) Internationale Veröffentlichungsnummer: WO 2014/023287

(56) Entgegenhaltungen:
- DE-B3-102005 012 496
- JP-A- 2000 114 314
- JP-A- 2005 197 488
- JP-A- 2006 310 477
- US-A1- 2004 183 182
- US-A1- 2004 197 979
- US-A1- 2008 295 318
- KIM J H ET AL: "Soldering Method Using Longitudinal Ultrasonic", IEEE TRANSACTIONS ON COMPONENTS AND PACKAGING TECHNOLOGIES, IEEE SERVICE CENTER, PISCATAWAY, NJ, US, Bd. 28, Nr. 3, 1. September 2005 (2005-09-01), Seiten 493-498, XP011138451, ISSN: 1521-3331, DOI: 10.1109/TCAPT.2005.848576

## Beschreibung

Die vorliegende Erfindung betrifft ein Verfahren zur Herstellung einer Kontakthöckerverbindung nach dem Oberbegriff des Anspruches 1 sowie eine Anordnung, die eine Kontakthöckerverbindung umfasst, gemäß dem Oberbegriff des Anspruches 6.

Kontakthöckerverbindungen der eingangs genannten Art dienen regelmäßig zur Kontaktierung von Anschlussflächen eines Chips mit Anschlussflächen eines Kontaktsubstrats. Insbesondere werden derartige Kontaktverbindungen, bei denen der Chip mittels eines so genannten "Flip-Chip"-Verfahrens mit seinen gegen die Anschlussflächen des Kontaktsubstrats gerichteten Anschlussflächen auf dem Kontaktsubstrat angeordnet wird, zur Herstellung von so genannten "kontaktlosen Chipkarten" verwendet, die mittels einer mit den Anschlussflächen des Kontaktsubstrats kontaktierten Antenne eine berührungslose Datenübertragung zwischen dem Chip und einem Datenlesegerät ermöglichen.

Ganz allgemein erfordert die "Flip-Chip"-Kontaktierung von Chips eine Präparierung der Anschlussflächen des Chips mit Kontakthöckern, die fachsprachlich auch häufig als "Bumps" bezeichnet werden. Mittels dieser Kontakthöcker ist es möglich, die Anschlussflächen des Chips mit den Anschlussflächen des Kontaktsubstrats elektrisch leitfähig zu kontaktieren, ohne dass Drahtleiter oder andere vom Chip unabhängige Kontakteinrichtungen notwendig sind.

Aus US 2004/0183182 A1 ist ein Verfahren bekannt, wobei die Kontakthöckern eines Chips mit den Anschlussflächen eines Substrats ohne zusätzliche Verbindungsmaterialien verbunden werden können.

Aus der DE 101 57 205 A1 ist ein Verfahren zur Herstellung von Kontakthöckern bekannt, das die Ausbildung von Kontakthöckern ermöglicht, die eine besondere Oberflächentopographie aufweisen, mit einem oberen Teil des Kontakthöckers, der Erhebungen aufweist, die beispielsweise säulen- oder sternförmig ausgebildet sind und eine verbesserte Aufnahme von Verbindungsmaterial ermöglichen sollen, das, wie beispielsweise Klebstoff oder ein Lotmaterial, die Herstellung einer elektrisch leitfähigen Verbindung zwischen den auf den Anschlussflächen des Chips angeordneten Kontakthöckern und Anschlussflächen eines Kontaktsubstrats ermöglichen soll. Weiterhin soll die bekannte Oberflächentopographie der Kontakthöcker das Aufbrechen von Oxidschichten auf den Anschlussflächen des Kontaktsubstrats ermöglichen und schließlich auch durch einen Eingriff der Erhebungen der Kontakthöcker einen mechanischen Verbund mit den Anschlussflächen des Kontaktsubstrats herstellen.

Hierzu werden Oberflächentopographien der Kontakthöcker vorgeschlagen, die auf einem Kontaktsockel des Kontakthöckers unterschiedlich ausgebildete oder unterschiedlich angeordnete Erhebungen aufweisen, wobei die Erhebungen sich entweder in einem zentralen Bereich des Kontaktsockels oder in einem Randbereich des Randsockels befinden und durch einen Eingriff in das Kontaktmaterial der Anschlussflächen des Kontaktsubstrats ein lokales Verzahnen mit der Kontaktmetallisierung des Kontaktsubstrats ermöglichen sollen. Bei Versuchen hat sich nun herausgestellt, dass Kontakthöckerverbindungen, die Kontakthöcker der vorstehend beschriebenen Art aufweisen, sich durch eine hohe Abscherfestigkeit auszeichnen. Jedoch sind die Zugfestigkeiten, die bei einem Versuch den Chip vom Kontaktsubstrat zu trennen erreicht werden, wenig befriedigend, so dass es bei den bekannten Kontakthöckerverbindungen zur ausreichenden mechanischen Sicherung zusätzlich zu der mechanischen Verbindung zwischen den Kontakthöckern und der Kontaktmetallisierung des Kontaktsubstrats notwendig ist, einen Kleber zwischen dem Chip und dem Kontaktsubstrat zu verwenden.

Als nachteilig hat es sich grundsätzlich bei der Verwendung von Kleber zur mechanisch haltbaren bzw. belastbaren Kontaktierung von Chips auf Kontaktsubstraten herausgestellt, dass in Folge der regelmäßig notwendigen Reaktionszeit für das Aushärten einer Kleberverbindung die erreichbaren Produktionszahlen bei der Herstellung derartiger Verbindungen begrenzt sind.

Der vorliegenden Erfindung liegt daher die Aufgabe zugrunde, ein Verfahren zu Herstellung einer Kontakthöckerverbindung und eine mit den Verfahrensschritten hergestellte Anordnung vorzuschlagen, die bereits ohne die Verwendung zusätzlicher Verbindungsmaterialien, wie insbesondere eines Klebers, die Herstellung einer dauerhaft haltbaren, den in der Praxis auftretenden mechanischen Belastungen widerstehenden mechanischen Verbindung ermöglicht.

Diese Aufgabe wird durch ein Verfahren mit den Merkmalen des Anspruchs 1 gelöst.

Erfindungsgemäß erfolgt zur Herstellung einer mechanischen Verbindung der Anschlussflächen ein Einpressen des auf der ersten Anschlussfläche angeordneten Kontakthöckers in eine Kontaktoberfläche eines Kontaktmaterials der zweiten Anschlussfläche, derart, dass im Verdrängungsraum des Kontakthöckers das Kontaktmaterial der zweiten Anschlussfläche während des Eindringens der Randüberhöhung und des Verdrängungszapfens bezogen auf die Einpressrichtung sowohl durch die Rand- Überhöhung radial nach innen als auch durch den Verdrängungszapfen radial nach außen mit Druck beaufschlagt wird, um das bereits vorstehend ausführlich erläuterte vorteilhafte radiale Anschmiegen bzw. Eindringen des Kontaktmaterials an bzw. in die durch die Randüberhöhung im Verdrängungsraum radial außen begrenzende Wandfläche des Verdrängungsraums und die den Verdrängungsraum radial innenseitig durch den Verdrängungszapfen gebildete Wandfläche des Verdrängungsraums zu ermöglichen.

Vorzugsweise wird in einer ersten Phase der Verbindungsherstellung das Kontaktmaterial der zweiten Anschlussfläche im Verdrängungsraum des Kontakthöckers durch die Randüberhöhung des Kontakthöckers bis zum Erreichen des freien Endes des Verdrängungszapfens radial nach innen mit Druck beaufschlagt, und in einer zweiten Phase der Verbindungsherstellung wird beim fortschreitenden Eindringen des Kontakthöckers in das Kontaktmaterial der zweiten Anschlussfläche das Kontaktmaterial durch die Randüberhöhung und den Verdrängungszapfen sowohl radial nach innen als auch radial nach außen mit Druck beaufschlagt.

Wenn das Einpressen des Kontakthöckers der ersten Anschlussfläche in das Kontaktmaterial der zweiten Anschlussfläche mit Schwingungen überlagert wird, kann die Eindringtiefe des Kontaktmaterials in die Wandflächen des Verdrängungsraums weiter gefördert werden.

Vorzugsweise erfolgt die Überlagerung mit Schwingungen in einer Ebene quer zur Einpressrichtung, wobei insbesondere eine an sich bekannte Ultraschalleinrichtung zur rückwärtigen Beaufschlagung des Chips mit der Einpresskraft und den Schwingungen quer zur Einpressrichtung verwendet werden kann.

Alternativ oder auch ergänzend kann die Überlagerung mit Schwingungen auch in Einpressrichtung erfolgen.

Als besonders vorteilhaft erweist sich die Anwendung des Verfahrens zur Herstellung einer Kontakthöckerverbindung zwischen einem mit ersten Anschlussflächen versehenen, als Chip ausgeführten elektronischen Bauelement und einem mit dem Bauelement kontaktierten als Antennensubstrat ausführten Kontaktsubstrat, wobei die Anschlussenden eines Antennenleiters gleichzeitig die Anschlussflächen des Kontaktsubstrats ausbilden.

Die erfindungsgemäße Anordnung weist die Merkmale des Anspruchs 6 auf.

Bei der erfindungsgemäßen Kontakthöckerverbindung ist die erste Anschlussfläche mit einem Kontakthöcker versehen, der eine Randüberhöhung und in einem durch die Randüberhöhung eingeschlossenen und zu einem Kopfende des Kontakthöckers hin offenen Verdrängungsraum zumindest einen Verdrängungszapfen aufweist, und die zweite Anschlussfläche weist in einem Kontaktbereich mit der ersten Anschlussfläche einen in dem Verdrängungsraum ausgebildeten, den Verdrängungszapfen umgebenden Kontaktwulst auf, mit einer zu einem Boden des Verdrängungsraums gerichteten und gegenüber einer den Kontaktbereich umgebenden ebenen Kontaktoberfläche der zweiten Anschlussfläche erhöhten Wulstkrone. Der Kontakthöcker und die zweite Anschlussfläche sind ohne zusätzliche Verbindungsmaterialien nach dem Verfahren von Anspruch 1 mechanisch verbunden.

Die erfindungsgemäße Kontakthöckerverbindung weist demnach einen Formschluss zwischen dem auf der ersten Anschlussfläche angeordneten Kontakthöcker und dem Kontaktmaterial der zweiten Anschlussfläche auf, wobei der Verdrängungsraum durch den Kontaktzapfen eine innere Begrenzung und durch die Randüberhöhung eine äußere Begrenzung aufweist, derart, dass eine Verdrängung des Kontaktmaterials innerhalb des Verdrängungsraums des Kontakthöckers in einem erheblichen Ausmaß erfolgt, so dass eine sich zum Boden des Verdrängungsraums erstreckende Wulstkrone ausgebildet ist und eine entsprechend weitreichende axiale Durchdringung zwischen dem Kontakthöcker und dem Kontaktmaterial die Folge ist. In Folge der sowohl radial inneren als auch radial äußeren Begrenzung des Verdrängungsraums durch den Verdrängungszapfen und die Randüberhöhung wird das Kontaktmaterial sowohl mit radial nach innen als auch radial nach außen gerichteten Druckkräften beaufschlagt, so dass an den Kontaktflächen zwischen dem Kontaktmaterial und dem Verdrängungszapfen einerseits und dem Kontaktmaterial und der Randüberhöhung andererseits eine Anschmiegung des Kontaktmaterials an die Oberflächentopographie der Randüberhöhung erfolgt, bei der durch das Kontaktmaterial etwaige Unebenheiten oder Vertiefungen in der Oberflächentopographie der Wände des Verdrängungsraums verfüllt und mögliche Hinterschneidungen in den Wänden des Verdrängungsraums ausgefüllt werden.

Die Folge hiervon ist, dass nicht nur eine axiale Durchdringung zwischen dem Kontakthöcker des elektronischen Bauelements, also etwa des Chips, und dem Kontaktmaterial des Kontaktsubstrats gegeben ist, sondern darüber hinaus auch eine radiale Durchdringung bzw. ein radiales Ineinandergreifen des Kontakthöckers und des Kontaktmaterials, so dass von der Kontakthöckerverbindung auf die Kontakthöckerverbindung trennend wirkende Zugbelastungen aufgenommen werden können.

Derartige Zugbelastungen treten beispielsweise bei einer Biegebelastung einer Chipkarte auf, die in der Praxis die maßgebliche, die Funktion einer Chipkarte gefährdende Belastung ist.

Bei einer bevorzugten Ausführungsform der Kontakthöckerverbindung ist die Randüberhöhung umlaufend ausgebildet und begrenzt den Verdrängungsraum peripher, so dass ein besonders starker Verdrängungseffekt erzielt wird.

Als besonders vorteilhaft für die Erreichung großer Zugfestigkeiten der Kontakthöckerverbindung erweist es sich, wenn ein freies Ende des Verdrängungszapfens unterhalb eines Oberrands der Randüberhöhung angeordnet ist, derart, dass der Verdrängungsraum aufgeteilt ist in einen sich vom freien Ende des Verdrängungszapfens bis zum Oberrand der Randüberhöhung erstreckenden verdrängungswiderstandsfreien Verdrängungsraumabschnitt und einen sich vom Boden des Verdrängungsraums bis zum freien Ende des Verdrängungszapfens erstreckenden, mit dem Verdrängungszapfen als Verdrängungswiderstand versehenen verdrängungswiderstandsbehafteten Verdrängungsraumabschnitt.

Der verdrängungswiderstandsfreie Verdrängungsraumabschnitt wird bei der Herstellung einer derartigen Kontakthöckerverbindung als erstes mit Kontaktmaterial gefüllt, wobei der Einpresswiderstand beim Herstellen der Verbindung während dieser ersten Phase aufgrund der Tatsache, dass sich in diesem verdrängungswiderstandsfreien Raum kein Verdrängungswiderstand befindet, mit relativ geringer Einpresskraft durchgeführt werden kann. Erst mit fortschreitender Verdrängung des Kontaktmaterials in den verdrängungswiderstandsbehafteten Verdrängungsraumabschnitt bei Fortsetzung des Einpressvorgangs erfolgt ein Anstieg der Einpresskraft bedingt durch den erhöhten Innendruck im verdrängungswiderstandsbehafteten Raum. Hierdurch ist es möglich, eine zielsichere Positionierung des Kontakthöckers beim Beginn des mechanischen Kontakts zum Kontaktmaterial bereits mit möglichst geringer Einpresskraft herzustellen und erst nach erfolgtem Kontakt die Einpresskraft zu erhöhen, um schließlich die Herstellung der mechanisch belastbaren formschlüssigen Verbindung durch Ausbildung der Wulstkrone im Verdrängungsraum abzuschließen.

Besonders vorteilhaft ist es, wenn der verdrängungswiderstandsbehaftete Verdrängungsraumabschnitt als Ringraum ausgebildet ist, so dass in der Kontaktebene zwischen dem Kontakthöcker und dem Kontaktmaterial eine symmetrische Druckbelastung die Folge ist.

Besonders vorteilhaft ist es, wenn die erste Anschlussfläche aus einer Anschlussfläche eines Chips oder eines Chipmoduls gebildet ist und die zweite Anschlussfläche aus einem Anschlussende eines Antennenleiters gebildet ist, so dass das Material zur Ausbildung des Antennenleiters gleichzeitig das Kontaktmaterial der Anschlussflächen des Kontaktsubstrats bildet und somit eine besonders unmittelbare Kontaktierung zwischen dem Kontakthöcker und einem auf dem Kontaktsubstrat ausgebildeten elektronischen Bauelement, nämlich dem Antennenleiter, ermöglicht wird.

Die erfindungsgemäße Anordnung, die einen Kontakthöcker umfasst, weist die Merkmale des Anspruchs 6 auf.

Erfindungsgemäß weist der Kontakthöcker eine Randüberhöhung und in einem von der Randüberhöhung umgebenen und zu einem Kopfende des Kontakthöckers offenen Verdrängungsraum zumindest einen Verdrängungszapfen auf, der in Kombination mit dem durch die Randüberhöhung radial außenseitig begrenzten Verdrängungsraum die bereits vorstehend ausführlich erläuterten Vorteile aufweist.

Vorzugsweise ist die Randüberhöhung umlaufend ausgebildet und begrenzt den Verdrängungsraum peripher, so dass die Randüberhöhung den Verdrängungsraum umschließt und ein besonders starker Verdrängungseffekt erzielt wird.

Vorzugsweise ist das freie Ende des Verdrängungszapfens unterhalb eines Oberrands der Randüberhöhung angeordnet, so dass der Kontakthöcker die Ausbildung der bereits vorstehend erläuterten Aufteilung des Verdrängungsraums in einen verdrängungswiderstandsfreien Verdrängungsraumabschnitt oberhalb des Verdrängungszapfens und einen verdrängungswiderstandsbehafteten Verdrängungsraumabschnitt aufweist, der vom Boden des Verdrängungsraums bis zum freien Ende des Verdrängungszapfens reicht.

Vorzugsweise ist durch die Anordnung des Verdrängungszapfens im Verdrängungsraum zwischen der Randüberhöhung und dem Verdrängungszapfen ein Ringraum ausgebildet.

Nachfolgend wird anhand der Zeichnung eine bevorzugte Ausführungsform eines Kontakthöckers sowie einer mittels des Kontakthöckers hergestellten Kontakthöckerverbindung näher erläutert.

Es zeigen:
- Fig. 1: einen Kontakthöcker in Schnittdarstellung;
- Fig. 2: eine Querschnittsdarstellung des in Fig. 1 dargestellten Kontakthöckers gemäß Schnittlinienverlauf II-II in Fig. 1;
- Fig. 3: eine Kontakthöckerverbindung in Schnittdarstellung;
- Fig. 4 bis Fig. 6: verschiedene Phasen der Herstellung einer Kontakthöckerverbindung.

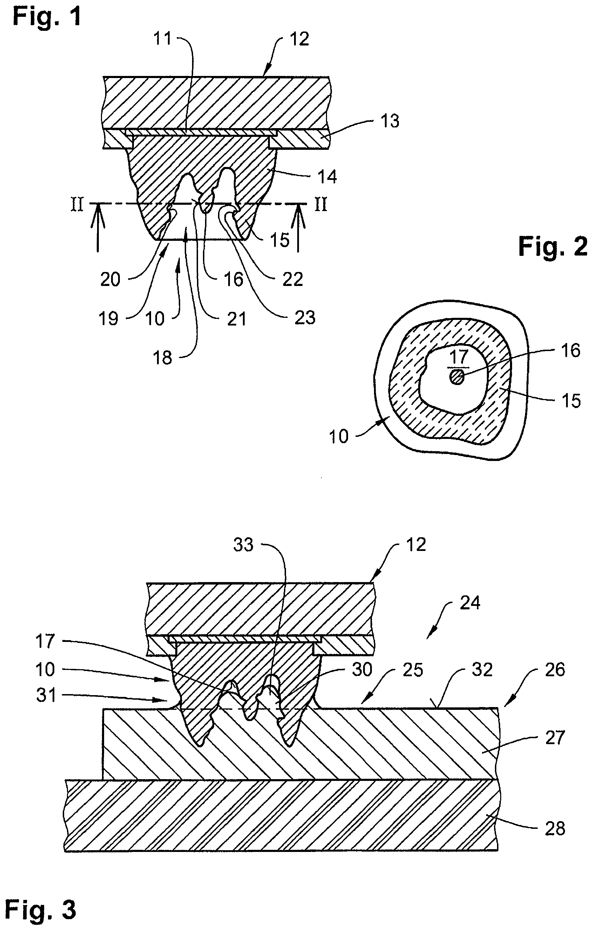

Fig. 1 zeigt einen Kontakthöcker 10, der auf einer Anschlussfläche 11 eines Chips 12 angeordnet ist, wobei eine dem Kontakthöcker benachbarte Chipoberfläche mit einer Passivierung 1 3 versehen ist.

Der in den Fig. 1 und 2 dargestellte Kontakthöcker 10 weist eine Kontakthöckerbasis 14 auf, die mit einer hier geschlossen ringförmig umlaufenden Randüberhöhung 15 und einem zentralen Verdrängungszapfen 16 versehen ist, der auf einem Boden 17 eines durch die Randüberhöhung 15 radial nach außen begrenzten Verdrängungsraumes 18 angeordnet ist.

Der in den Fig. 1 und 2 dargestellte Kontakthöcker 10 kann grundsätzlich auf unterschiedliche Art und Weise hergestellt werden, wobei sich zur Herstellung des Kontakthöckers 10 in besonderer Weise eine Herstellung mittels stromloser Palladiumabscheidung oder Abscheidung einer Palladium-Legierung in Kombination mit einem fotolithografischen Verfahren auf der Anschlussfläche 11 des Chips 12 eignet, wie beispielsweise in der WO 2000/048242 A1 beschrieben.

Mit dem Abscheideverfahren kann die in Fig. 1 dargestellte Topographie der Oberfläche des Kontakthöckers 10 hergestellt werden, wobei eine den Verdrängungsraum 18 radial außen begrenzende im Wesentlichen sich zu einer Verdrängungsraumöffnung 19 hin konisch erweiternde Außenwand 20 und eine durch den Verdrängungszapfen 16 definierte sich konisch zur Verdrängungsraumöffnung 19 hin verjüngende Innenwand 21 des Verdrängungsraums mit Unregelmäßigkeiten versehen sind, die Vorsprünge 22 und Vertiefungen 23 ausbilden.

Fig. 3 zeigt eine Kontakthöckerverbindung 24, bei der der auf der Anschlussfläche 11 des Chips 12 angeordnete Kontakthöcker 10 mit einer Anschlussfläche 25 eines Kontaktsubstrats 26 verbunden ist, wobei im vorliegenden Fall die Anschlussfläche 25 durch ein Anschlussende eines Antennenleiters 27 gebildet ist, der drahtförmig oder in Form einer beispielsweise durch Beschichtung erzeugten Leiterbahnstruktur auf einem hier als Trägerfolie 28 ausgebildeten Substrat angeordnet ist.

Zur Herstellung der in Fig. 3 dargestellten Kontakthöckerverbindung 24 wird der Kontakthöcker 10 von oben in die durch das Anschlussende des Antennenleiters 27 gebildete Anschlussfläche 25 eingepresst, wobei das im vorliegenden Fall durch den Antennenleiter 27 gebildete Kontaktmaterial 29 in den Verdrängungsraum 18 verdrängt wird, bis sich schließlich am Ende des Einpressvorgangs eine Verformung des Kontaktmaterials 29 ergeben hat, wie in Fig. 3 dargestellt, derart, dass innerhalb des Verdrängungsraums 18 ein den Verdrängungszapfen 16 umschließender Kontaktwulst 30 ausgebildet ist mit einer zum Boden 17 des Verdrängungsraums 18 gerichteten und gegenüber einer einen Kontaktbereich 31 zwischen dem Kontakthöcker 10 und der Anschlussfläche 25 umgebenden Kontaktoberfläche 32 erhöhten Wulstkrone 33.

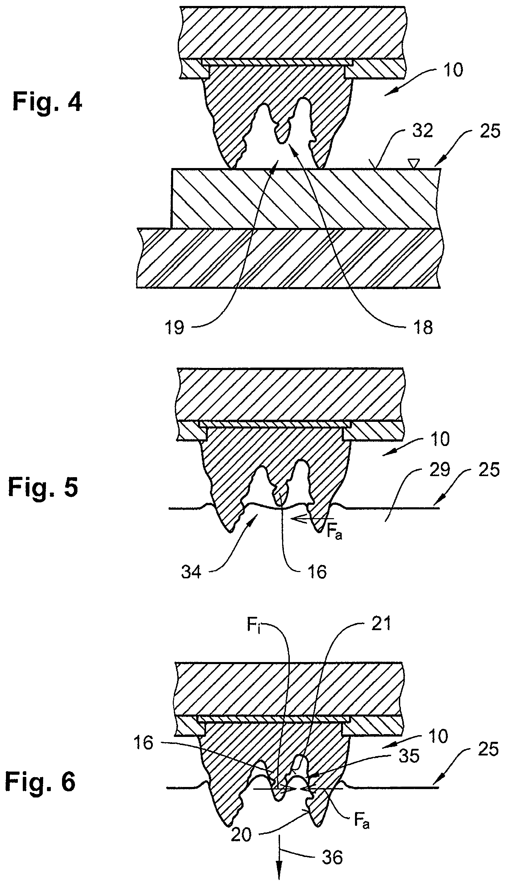

In den Fig. 4 bis 6 ist der Einpressvorgang in seinen unterschiedlichen Phasen schematisch dargestellt, wobei Fig. 4 den Kontakthöcker 10 unmittelbar vor dem Eindringen in die noch eben ausgebildete Kontaktoberfläche 32 der Anschlussfläche 25 zeigt. Fig. 5 zeigt eine erste Verdrängungsphase, bei der das Kontaktmaterial 29 durch die Verdrängungsraumöffnung 19 in einen Verdrängungsraumabschnitt 34 eindringt, der keinen Verdrängungskörper aufweist, so dass die Verdrängung des Kontaktmaterials 29 in den Verdrängungsraumabschnitt 34 überwiegend in Folge eines radial von außen durch die Außenwand 20 des Verdrängungsraums 18 auf das Kontaktmaterial 29 einwirkenden Verdrängungsdrucks Fₐ erzeugt wird.

Bei Fortsetzung des Einpressvorgangs erreicht das in den Verdrängungsraum 18 verdrängte Kontaktmaterial 29, wie in Fig. 6 dargestellt, einen Verdrängungsraumabschnitt 35, der den Verdrängungszapfen 16 als Verdrängungskörper aufweist, so dass in den Verdrängungsraumabschnitt 35 nicht nur von radial außen durch die Außenwand 20 des Verdrängungsraums 18, sondern auch von radial innen durch die vom Verdrängungszapfen 16 gebildete Innenwand 21 ein nach innen gerichteter Verdrängungsdruck Fᵢ auf das Kontaktmaterial wirkt, mit der Folge, dass die Verdrängung unter Ausbildung der in Fig. 3 dargestellten Wulstkrone 33 beschleunigt und verbunden mit einem Anstieg der zum Einpressen notwendigen Kraft erfolgt.

In Folge des auf das Kontaktmaterial 29 wirkenden Außendrucks Fₐ und des auf das Kontaktmaterial 29 wirkenden Innendrucks Fᵢ erfolgt eine Anschmiegung des Kontaktmaterials 29 an die Außenwand 20 und die Innenwand 21 des Verdrängungsraums 18 , wobei das Kontaktmaterial der Kontur der Vorsprünge 22 in der Außenwand 20 und der Innenwand 21 folgt und ebenso in die Vertiefungen 23 der Außenwand 20 und der Innenwand 21 eingepresst wird, so dass nicht nur ein axialer Eingriff zwischen dem Kontakthöcker 10 und dem Kontaktmaterial 29 in Einpressrichtung 36 erfolgt, sondern auch quer bzw. radial zur Einpressrichtung 36.

Für den Fall, dass eine zusätzliche Verstärkung der mechanischen Verbindung zwischen dem elektronischen Bauelement, also etwa dem Chip, und dem Kontaktsubstrat gewünscht wird, kann vor oder nach Herstellung der Kontakthöckerverbindung in der Umgebung des Kontakthöckers und/oder in der Umgebung der Anschlussfläche des Kontaktsubstrats ein Polymer-Kleber auf das elektronische Bauelement und/oder das Kontaktsubstrat aufgebracht werden.

Insbesondere bei Verwendung eines drucksensitiven Klebers kann die Vernetzung des Klebers während der Herstellung der Kontakthöckerverbindung erfolgen. Bei Verwendung eines temperatursensitiven Klebers kann die Vernetzung durch nachträgliche Temperaturbeaufschlagung nach Herstellung der Kontakthöckerverbindung erfolgen.

Grundsätzlich ist eine ausreichend mechanisch belastbare Kontakthöckerverbindung auch ohne zusätzliche Klebeverbindung gegeben, so dass etwaige Reaktionszeiten zur Vernetzung bzw. Aushärtung des Klebers ohne Einfluss auf die zur Herstellung der Kontakthöckerverbindung benötigte Zeit sind. Die Verbindungszeit wird allein von der Dauer des Einpressvorgangs bei der Herstellung der Kontakthöckerverbindung bestimmt.

## Patentansprüche

1. Verfahren zur Herstellung einer Kontakthöckerverbindung (24) zwischen einem mit zumindest einer ersten Anschlussfläche (11) versehenen elektronischen Bauelement und einem mit dem Bauelement kontaktierten Kontaktsubstrat (26) mit zumindest einer zweiten Anschlussfläche (25) wobei die erste Anschlussfläche mit einem Kontakthöcker (10) versehen ist, der eine Randüberhöhung (15) und in einem von der Randüberhöhung umgebenen und zu einem Kopfende des Kontakthöckers hin offenen Verdrängungsraum (18) zumindest einen Verdrängungszapfen (16) aufweist, **dadurch gekennzeichnet,**
**dass** die Herstellung einer mechanischen Verbindung des Kontakthöckers (10) mit der zweiten Anschlussfläche (25) ohne zusätzliche Verbindungsmaterialien erfolgt, und zwar derart, dass ein Einpressen des auf der ersten Anschlussfläche (11) angeordneten Kontakthöckers (10) in eine Kontaktoberfläche (32) eines Kontaktmaterials (29) der zweiten Anschlussfläche (25) erfolgt, derart, dass im Verdrängungsraum (18) des Kontakthöckers das Kontaktmaterial der zweiten Anschlussfläche während des Eindringens der Randüberhöhung (15) und des Verdrängungszapfens (16) bezogen auf die Einpressrichtung (36) sowohl durch die Randüberhöhung radial nach innen als auch durch den Verdrängungszapfen radial nach außen mit Druck beaufschlagt wird.

2. Verfahren nach Anspruch 1, **dadurch gekennzeichnet,**
**dass** in einer ersten Phase der Verbindungsherstellung das Kontaktmaterial (29) der zweiten Anschlussfläche (25) im Verdrängungsraum (18) des Kontakthöckers (10) durch die Randüberhöhung (15) des Kontakthöckers bis zum Erreichen des freien Endes des Verdrängungszapfens (16) radial nach innen mit Druck beaufschlagt wird, und in einer zweiten Phase der Verbindungsherstellung beim fortschreitenden Eindringen des Kontakthöckers in das Kontaktmaterial der zweiten Anschlussfläche das Kontaktmaterial durch die Randüberhöhung und den Verdrängungszapfen sowohl radial nach innen als auch radial nach außen mit Druck beaufschlagt wird.

3. Verfahren nach Anspruch 1 oder 2, **dadurch gekennzeichnet,**
**dass** das Einpressen des Kontakthöckers (10) der ersten Anschlussfläche (11) in das Kontaktmaterial (29) der zweiten Anschlussfläche (25) mit Schwingungen überlagert wird.

4. Verfahren nach Anspruch 3, **dadurch gekennzeichnet,**
**dass** die Überlagerung mit Schwingungen in einer Ebene quer zur Einpressrichtung (36) erfolgt.

5. Verfahren nach Anspruch 3, **dadurch gekennzeichnet,**
**dass** die Überlagerung mit Schwingungen in Einpressrichtung (36) erfolgt.

6. Anordnung umfassend ein mit zumindest einer ersten Anschlussfläche (11) versehenes elektronisches Bauelement und einen mit dem Bauelement kontaktierten und mit zumindest einer zweiten Anschlussfläche (25) versehenes Kontaktsubstrat (26), die Anordnung umfassend eine Kontakthöckerverbindung (24) zwischen der ersten Anschlussfläche (11) und zweiten Anschlussfläche (25), wobei die erste Anschlussfläche mit einem Kontakthöcker (10) versehen ist, der eine Randüberhöhung (15) und in einem von der Randüberhöhung umgebenen und zu einem Kopfende des Kontakthöckers hin offenen Verdrängungsraum (18) zumindest einen Verdrängungszapfen (16) aufweist, **dadurch gekennzeichnet, dass** der Kontakthöcker (10) und die zweite Anschlussfläche (25) ohne zusätzliche Verbindungsmaterialien nach dem Verfahren von Anspruch 1 mechanisch verbunden sind, wobei die zweite Anschlussfläche in einem Kontaktbereich (31) mit der ersten Anschlussfläche einen in dem Verdrängungsraum ausgebildeten, den Verdrängungszapfen umgebenden Kontaktwulst (30) aufweist, mit einer zu einem Boden (17) des Verdrängungsraums gerichteten und gegenüber einer den Kontaktbereich umgebenden ebenen Kontaktoberfläche (32) der zweiten Anschlussfläche erhöhten Wulstkrone (33).

7. Anordnung nach Anspruch 6, **dadurch gekennzeichnet,**
**dass** die Randüberhöhung (15) umlaufend ausgebildet ist und den Verdrängungsraum (18) peripher begrenzt.

8. Anordnung nach Anspruch 6 oder 7, **dadurch gekennzeichnet,**
**dass** ein freies Ende des Verdrängungszapfens (16) unterhalb eines Oberrands der Randüberhöhung (15) angeordnet ist, derart, dass der Verdrängungsraum (18) aufgeteilt ist in einen sich vom freien Ende des Verdrängungszapfens bis zum Oberrand der Randüberhöhung erstreckenden verdrängungswiderstandsfreien Verdrängungsraumabschnitt (34) und einen sich vom Boden (17) des Verdrängungsraums bis zum freien Ende des Verdrängungszapfens erstreckenden, mit dem Verdrängungszapfen als Verdrängungswiderstand versehenen verdrängungswiderstandsbehafteten Verdrängungsraumabschnitt (35).

9. Anordnung nach Anspruch 8, **dadurch gekennzeichnet,**
**dass** der verdrängungswiderstandsbehaftete Verdrängungsraumabschnitt (35) als Ringraum ausgebildet ist.

10. Anordnung nach einem der Ansprüche 6 bis 9, **dadurch gekennzeichnet,**
**dass** die erste Anschlussfläche (11) aus einer Anschlussfläche eines Chips (12) oder eines Chipmoduls gebildet ist und die zweite Anschlussfläche (25) aus einem Anschlussende eines Antennenleiters (27) gebildet ist.

## Claims

1. Method for producing a contact bump connection (24) between an electronic component provided with at least one first terminal face (11) and a contact substrate (26) with at least one second terminal face (25), said contact substrate being contacted with the component, wherein the first terminal face is provided with a contact bump (10) having a raised edge (15) and at least one displacement pin (16) in a displacement space (18) surrounded by the raised edge and open towards a head end of the contact bump, **characterized in that** a mechanical connection between the contact bump (10) and the second terminal face (25) is produced without additional connection materials, specifically in such a way that the contact bump (10) arranged on the first terminal face (11) is press-fitted into a contact surface (32) of a contact material (29) of the second terminal face (25) in such a way that in the displacement space (18) of the contact bump the contact material of the second terminal face is subjected to pressure both radially inwardly by the raised edge and radially outwardly by the displacement pin relative to the press-fit direction (36) during the penetration of the raised edge (15) and of the displacement pin (16).

2. Method according to Claim 1, **characterized**
**in that** in a first phase of producing the connection, the contact material (29) of the second terminal face (25), in the displacement space (18) of the contact bump (10), is subjected to pressure radially inwardly by the raised edge (15) of the contact bump until the free end of the displacement pin (16) is reached, and in a second phase of producing the connection, as the contact bump progressively penetrates into the contact material of the second terminal face, the contact material is subjected to pressure both radially inwardly and radially outwardly by the raised edge and the displacement pin.

3. Method according to Claim 1 or 2, **characterized**
**in that** the press-fitting of the contact bump (10) of the first terminal face (11) into the contact material (29) of the second terminal face (25) is superimposed with oscillations.

4. Method according to Claim 3, **characterized**
**in that** the superimposition with oscillations is carried out in a plane transversely with respect to the press-fit direction (36).

5. Method according to Claim 3, **characterized**
**in that** the superimposition with oscillations is carried out in the press-fit direction (36).

6. Arrangement comprising an electronic component provided with at least one first terminal face (11) and a contact substrate (26) provided with at least one second terminal face (25) and contacted with the component, the arrangement comprising a contact bump connection (24) between the first terminal face (11) and the second terminal face (25), wherein the first terminal face is provided with a contact bump (10) having a raised edge (15) and at least one displacement pin (16) in a displacement space (18) surrounded by the raised edge and open towards a head end of the contact bump, **characterized**
**in that** the contact bump (10) and the second terminal face (25) are mechanically connected without additional connection materials according to the method from Claim 1, wherein the second terminal face has in a contact region (31) with the first terminal face a contact bead (30) formed in the displacement space and surrounding the displacement pin, with a bead crown (33) directed towards a base (17) of the displacement space and raised relative to a planar contact surface (32) - surrounding the contact region - of the second terminal face.

7. Arrangement according to Claim 6, **characterized**
**in that** the raised edge (15) is formed in a manner extending circumferentially and peripherally delimits the displacement space (18).

8. Arrangement according to Claim 6 or 7, **characterized**
**in that** a free end of the displacement pin (16) is arranged below an upper edge of the raised edge (15) in such a way that the displacement space (18) is divided into a displacement-resistance-free displacement space section (34) extending from the free end of the displacement pin to the upper edge of the raised edge and a displacement-resistance-exhibiting displacement space section (35) extending from the base (17) of the displacement space to the free end of the displacement pin and provided with the displacement pin as displacement resistance.

9. Arrangement according to Claim 8, **characterized in that** the displacement-resistance-exhibiting displacement space section (35) is formed as a ring space.

10. Arrangement according to any of Claims 6 to 9, **characterized**
**in that** the first terminal face (11) is formed from a terminal face of a chip (12) or of a chip module and the second terminal face (25) is formed from a terminal end of an antenna conductor (27).

## Revendications

1. Procédé d'obtention d'une connexion de plots de contact (24) entre un composant électronique pourvu d'au moins une première surface de connexion (11) et un substrat de contact (26) mis en contact avec le composant et pourvu d'au moins une deuxième surface de connexion (25), dans lequel la première surface de connexion est pourvue d'un plot de contact (10) qui présente un bord surhaussé (15) et dans un espace de refoulement (18) entouré par le bord surhaussé et ouvert en direction d'une extrémité frontale du plot de contact au moins une cheville de refoulement (16), **caractérisé en ce que** l'obtention d'une connexion mécanique du plot de contact (10) avec la deuxième surface de connexion (25) est effectuée sans matériaux de connexion supplémentaires, et notamment **en ce qu'**un enfoncement du plot de contact (10) disposé sur la première surface de connexion (11) dans une surface de contact (32) d'un matériau de contact (29) de la deuxième surface de connexion (25) est effectué de telle sorte que dans l'espace de refoulement (18) du plot de contact, le matériau de contact de la deuxième surface de connexion, pendant la pénétration du bord surhaussé (15) et de la cheville de refoulement (16), par rapport à la direction d'enfoncement (36), est mis sous pression aussi bien radialement vers l'intérieur par le bord surhaussé que radialement vers l'extérieur par la cheville de refoulement.

2. Procédé selon la revendication 1, **caractérisé en ce que** dans une première phase de l'obtention de connexion, le matériau de contact (29) de la deuxième surface de connexion (25) dans l'espace de refoulement (18) du plot de contact (10) est mis sous pression radialement vers l'intérieur par le bord surhaussé (15) du plot de contact jusqu'à ce que l'extrémité libre de la cheville de refoulement (16) soit atteinte, et dans une deuxième phase de l'obtention de connexion, lorsque la pénétration du plot de contact dans le matériau de contact de la deuxième surface de connexion se poursuit, le matériau de contact est mis sous pression aussi bien radialement vers l'intérieur que radialement vers l'extérieur par le bord surhaussé et la cheville de refoulement.

3. Procédé selon la revendication 1 ou 2, **caractérisé en ce que** l'enfoncement du plot de contact (10) de la première surface de connexion (11) dans le matériau de contact (29) de la deuxième surface de connexion (25) est associé à des oscillations.

4. Procédé selon la revendication 3, **caractérisé en ce que** les oscillations associées ont lieu dans un plan transversalement à la direction d'enfoncement (36).

5. Procédé selon la revendication 3, **caractérisé en ce que** les oscillations associées ont lieu dans la direction d'enfoncement (36).

6. Ensemble, comprenant un composant électronique pourvu d'au moins une première surface de connexion (11) et un substrat de contact (26) mis en contact avec le composant et pourvu d'au moins une deuxième surface de connexion (25), l'ensemble comprenant une connexion de plots de contact (24) entre la première surface de connexion (11) et la deuxième surface de connexion (25), dans lequel la première surface de connexion est pourvue d'un plot de contact (10) qui présente un bord surhaussé (15) et dans un espace de refoulement (18) entouré par le bord surhaussé et ouvert en direction d'une extrémité frontale du plot de contact au moins une cheville de refoulement (16), **caractérisé en ce que** le plot de contact (10) et la deuxième surface de connexion (25) sont reliés mécaniquement sans matériaux de connexion supplémentaires selon le procédé de la revendication 1, dans lequel la deuxième surface de connexion présente dans une zone de contact (31) avec la première surface de connexion un bourrelet de contact (30) réalisé dans l'espace de refoulement, entourant la cheville de refoulement et pourvu d'une couronne de bourrelet (33) orientée en direction d'un fond (17) de l'espace de refoulement et rehaussée par rapport à une surface de contact plate (32) de la deuxième surface de connexion et qui entoure la zone de contact.

7. Ensemble selon la revendication 6, **caractérisé en ce que** le bord surhaussé (15) est réalisé de manière circonférentielle et limite l'espace de refoulement (18) en périphérie.

8. Ensemble selon la revendication 6 ou 7, **caractérisé en ce qu'**une extrémité libre de la cheville de refoulement (16) est disposée au-dessous d'un bord supérieur du bord surhaussé (15) de telle sorte que l'espace de refoulement (18) est divisé en une partie d'espace de refoulement (34) sans résistance au refoulement et s'étendant depuis l'extrémité libre de la cheville de refoulement jusqu'au bord supérieur du bord surhaussé et une partie d'espace de refoulement (35) avec résistance au refoulement et s'étendant depuis le fond (17) de l'espace de refoulement jusqu'à l'extrémité libre de la cheville de refoulement, pourvue de la cheville de refoulement comme élément résistant au refoulement.

9. Ensemble selon la revendication 8, **caractérisé en ce que** la partie d'espace de refoulement avec résistance au refoulement (35) est réalisée sous la forme d'un espace annulaire.

10. Ensemble selon l'une quelconque des revendications 6 à 9, **caractérisé en ce que** la première surface de connexion (11) est formée à partir d'une surface de connexion d'une puce (12) ou d'un module de puce et la deuxième surface de connexion (25) est formée à partir d'une extrémité de connexion d'un conducteur d'antenne (27) .
